Europäisches Patentamt

European Patent Office

Office européen des brevets

(19)

(11) Publication number: **0 295 895**
**A1**

(12) # EUROPEAN PATENT APPLICATION

(21) Application number: **88305471.0**

(51) Int. Cl.⁴: **H01L 41/22 , C08L 11/00**

(22) Date of filing: **15.06.88**

(30) Priority: **16.06.87 US 64149**

(43) Date of publication of application:
**21.12.88 Bulletin 88/51**

(84) Designated Contracting States:
**DE FR GB IT**

(71) Applicant: **WESTINGHOUSE ELECTRIC CORPORATION**
**Westinghouse Building Gateway Center**
**Pittsburgh Pennsylvania 15222(US)**

(72) Inventor: **Siemon, John Thomas**
**717 Heathergate Drive**
**Pittsburgh, PA 19238(US)**
Inventor: **Meier, Joseph Francis**
**2375 Harrison City Road**
**Export, PA 15632(US)**

(74) Representative: **van Berlyn, Ronald Gilbert**
**23, Centre Heights**
**London, NW3 6JG(GB)**

(54) **Piezoceramic composite.**

(57) Disclosed is a method of making a piezoceramic composite by mixing together a composition of an uncured polar elastomeric chloroprene rubber, about 2.5 to about 7.5 phr of a peptizer for the chloroprene rubber, about 2 to about 6 phr magnesium oxide, about 30 to about 38 phr of an aliphatic oil plasticizer for the rubber, mixing into the composition about 1750 to about 3000 phr of a piezoelectric ceramic crystalline powder selected from the group consisting of lead titanate, lead zirconium titanate, and mixtures thereof, mixing into the composition about 2.5 to about 7.5 phr zinc oxide and about 0.5 to about 1 phr of a sulfur-containing chloroprene rubber curing agent, forming the composition into a shape, applying electrodes to opposite sides of the shape, curing the chloroprene rubber, and applying a DC electric field to said shape through said electrodes.

EP 0 295 895 A1

# PIEZOCERAMIC COMPOSITE

Moving underwater objects can be detected by means of hydrophones. These hydrophones can consist of piezoelectric materials which generate an electric current in response to changes in pressure. A particularly good piezoelectric material is lead titanate, a crystalline powder that is usually embedded in a matrix of chloroprene rubber. While this is an excellent piezoelectric material for use in hydrophones, improvements in the sensitivity of the material are nevertheless desirable.

We have discovered a method of making a piezoceramic composite that employs lead titanate or a similar material. The method of this invention results in a composite that is more sensitive to pressure changes than identical composites prepared by previous methods. That is, the method of this invention results in a composite that generates a greater amount of electricity for a given pressure change (in the direction perpendicular to the composite) than do previous composites prepared by other methods using the same materials.

The composition used in making the composite of this invention is prepared on a mixer such as, for example, a two-roll mill or a Banbury mixer. To produce the product in the form of a sheet a two-roll mill or a calendar is used.

In the first step of the process of this invention, an uncured polar elastomeric chloroprene rubber is placed in the mixer. This is a very high viscosity material that can best be described as a semi-solid, yet because it is uncured, its viscosity will increase when it is cured; prior to curing, it is still formable. We have found that it is necessary for the rubber used to be polar as related materials, such as butyl rubber, which are not polar, do not result in a composite that has acceptable piezoelectric characteristics. While any type of chloroprene rubber may be used, a chloroprene rubber that has a Mooney viscosity of about 42 to about 57 (on an ML 1 spindel at 100°C) is preferred as it seems to result in composites that have the greatest sensitivity. Chloroprene is sold by Dupont Corporation under the trademark "Neoprene," and the preferred chloroprene rubber is sold as "Neoprene TRT."

In the second step of the process of this invention, an activator/processing aid is added to the rubber in the mixer. An activator/processing aid performs the function of aiding in the rubber mixing process so that the rubber mixes more easily, and it is also part of the curing system. Suitable activator/processing aids are well known in the industry and include fatty acids such as stearic acid. Stearic acid is preferred as it has been found to work very well and is cost effective. The activator/processing aid is added in an amount of about 2.5 to about 7.5 phr (parts per hundred part rubber, where "rubber" means the chloroprene rubber) as it is difficult to process and cure the rubber if less is used, and more may result in a composition that is too waxy, too spongy, and too flexible.

In the next step of the process of this invention, magnesium oxide is added to the mixer and is mixed into the composition. Magnesium oxide is also part of the curing system and, at the present time, equivalents for magnesium oxide are unknown. The magnesium oxide is added in an amount of about 2 to about 6 phr as less may result in an incomplete cure and more may result in magnesium oxide that is not reacted into the rest of the composition.

In the next step, a plasticizer is mixed into the composition. Any paraffinic oil can be used as a plasticizer. A preferred plasticizer is a sulfonic acid/ paraffinic oil sold by Vanderbilt Chemical Company under the trade designation, "Plastogen." The plasticizer is added in an amount of about 20 to about 50 phr as if less is used it may be difficult to work all of the piezoceramic material into the composition, and if more is used the plasticizer may not be be entirely absorbed and it may be difficult to align the crystals during poling. If a two-roll mill is being used, each of the foregoing components should be added one at a time to the mill, but, if a Banbury mixer is used, the preceding four components can be added together. In either event, all of the preceding four components must be added before the next component is mixed in.

In the next step, the piezoelectric ceramic crystalline powder is added to the composition. This powder can be either lead titanate ($PbTiO_3$) or "PZT," which is lead zirconium titanate ($PbZrTiO_3$). Lead titanate is preferred as it results in a more sensitive piezo-composite. Especially preferred is a lead titanate that is prepared according to European patent application No. 0253512-A2. Lead titanate prepared according to that application is preferred because it is more sensitive than lead titanate prepared by other methods. Briefly, the lead titanate of that patent application is prepared by heating powdered crystalline lead titanate in the presence of lead oxide, thereby growing crystals that have an average equivalent spherical diameter grain size of about 8 to about 15 microns and a grain size distribution between 10% and 90%, of about 0.3 to about 2.5 times the average. The crystals are etched to smooth their surfaces and to remove extra-fine particles for a time sufficient to create an average equivalent spherical diameter grain size of about 12 to about 20 microns and a grain size distribution, between 10% and 90%, of about 0.6 to about 1.35 times the average. The etched crystals are then rinsed and dried. The amount of piezoceramic material should be about 1,750 to about 3,000 phr as if less is used the composite will not be as sensitive and if more is used it will be difficult to process the composition. It is important that the piezoelectric crystals be added to the composition prior to the addition of zinc oxide in the next step because the frictional heat generated in mixing in the piezoelectric crystals could result in the cure of the chloroprene rubber if the zinc oxide were present.

In the next step, zinc oxide, a curing agent, is added to the composition. At the present time equivalents to zinc oxide are not known, though they may be developed at some time in the future. The amount of zinc oxide should be about 2.5 to about 7.5 phr as if less is used the composition may not cure completely and there does not appear to be any benefit to using more.

At this time a sulfur-containing curing agent is also added to the composition. The sulfur-containing curing agent cures the rubber by a different mechanism than does the zinc oxide, but the presence of both curing agents seem to be essential to obtaining a complete cure. Examples of suitable sulfur-containing curing agents include thiazoles, thioureas, and mercaptans. The preferred sulfur-containing curing agent is ethylene thiourea because it has been found to work very well. The amount of sulfur-containing curing agent should be about 0.5 to about 2 phr as if less is used the cure may be incomplete and if more is used the curing reaction may be too rapid. The sulfur-containing curing agent can be added before, with, or after the zinc oxide. Also, if a Banbury mixer is being used, the zinc oxide and the sulfur-containing curing agent can be added together.

The composition is then formed into shape. This can be accomplished in a variety of ways, including milling or extruding to form a flat sheet, or co-extruding or injection molding over a conductor (which can then become one of the electrodes). After a shape has been formed, the composition is cured with heat. It is preferable to cure the rubber in two steps, the first step being a partial cure and the second step fully curing the rubber. Curing conditions depend upon the particular chloroprene rubber being used and can be obtained from the manufacturer of the rubber. A temperature of about 121.11°C to about 232.22°C is preferred as lower temperatures require too much time to cure and higher temperatures may degrade the rubber. A typical cure is at about 160°C for about 10 minutes. It is preferable to press the composition during curing in order to consolidate or densify it, and help form it into a shape. A preferred pressure range during cure is about 3.52 kg/sq cm to 10.55 kg/sq cm as higher pressures are unnecessary and lower pressures are of only marginal benefit.

After the partial or full cure of the neoprene rubber, the electrodes are applied to opposite sides of the shape to form a sandwich type construction. The application of the electrodes to the shape can also be performed before the partial cure if desired. Many types of electrodes may be used in forming the composite. For example, silver paint may be applied to opposite sides of the shape. A preferred electrode is a partially cured conductive chloroprene sheet that is placed on each side of a chloroprene sheet that contains the piezoceramic material. During full cure, the partially cured chloroprene electrode then bonds securely to the chloroprene that contains piezoceramic material.

If the chloroprene has been only partially cured, it is then fully cured. Full cure can usually be achieved by repeating the same conditions used during partial cure. For example, 10 minutes at 160°C under pressure is usually adequate.

In the last step of the process of this invention, a poling electric field is applied through the electrodes to align the piezoceramic crystals in the 33 direction, i.e., along the polarization axis. The alignment of the crystals in that direction is essential to obtaining a piezoelectric composite. The poling electric field is a DC field which is preferably between about 100 and about 300 Kv per 0.025 mm of thickness of the shape (excluding electrodes). Less than 100 Kv per 0.025 mm may be inadequate to align the crystals and more than 300 Kv per 0.025 mm is probably unnecessary and may result in the electrical shorting of the material. The application of the poling electric field is preferably done in hot oil at about 80°C to about 100°C for about 1 to $1\frac{1}{2}$ hours in order to soften the chloroprene rubber and facilitate the realignment of the crystals.

In addition to its use in hydrophones as part of underwater detection devices, the composite of this invention can also be used in other types of mechanical/thermal/electrical conversion transducers and sonic receivers. Examples of such other applications include tactile sensors for robotics and bionics, conversion of mechanical wave pulses to electricity such as in hydroelectrics and ocean wave power generating facilities, as well as other devices that involve the conversion of sound into electricity or electricity into sound. Also, this material can be used as a heat sensor since it is also pyroelectric.

The following example further illustrates this invention.

EXAMPLE

The following ingredients were added one at a time using a two-roll rubber mill and were processed on the mill.

| Ingredients | Amount (phr) | Density (g/cc) | Volume (cc) |
|---|---|---|---|
| Neoprene TRT | 100 | 1.25 | 80 |
| Stearic Acid | 0.5 | 0.84 | 0.6 |
| Magnesium Oxide | 4.0 | 3.32 | 1.2 |
| "Plastogen" | 40 | 0.81 | 49.4 |
| Lead Titanate | 2100 | 7.52 | 279.3 |
| Zinc Oxide | 5.0 | 5.60 | 0.9 |
| Ethylene Thiourea | 1.0 | 1.0 | 1.0 |

The lead titanate used in this example was a conventionally prepared lead titanate. After all of the ingredients had been mixed on the two roll mill, the mixture was sheeted from the mill and pressed to 2.03 mm at 160° C for 20 minutes at 19.68 kg/sq cm. The order of ingredient addition, as will be clear from the examples which follow, was found to be critical to obtaining satisfactory material and satisfactory processing properties. After curing at 160° C for 20 minutes, approximately 6.45 sq cm samples were cut from the molded slab and were painted with silver paint on each side to form electrodes for poling. The samples were immersed into hot silicone oil at 100° C and a voltage potential of 250 volts per 0.025 mm thickness was applied across the sample thickness through the electrodes for one hour. The piezoelectric properties were then measured and the composites were found to have a $d_{33}$ (the ratio of electric charge generated per unit area to the applied force per unit area in the 33 direction) equal to 8 to 15 pC/N (picocoulombs per Newton). applied force per unit area in the 33 direction) equal to 8 to 15 pC/N (picocoulombs per Newton).

EXAMPLE 2

Example 1 was repeated except that the lead titanate was specially prepared as described in European patent application No. 0253512-A2. The piezoelectric properties of this sample were found to be $d_{33} = 45$ pC/N for a sample poled for 10 minutes and $d_{33} = 50$ pC/N for a sample poled for one hour. Further tests showed that the sample had about the same $d_h$ (where $d_h = d_{33} - (d_{31} + d_{32})$) regardless of the pressure generating the electricity, as is shown in the following table:

| Pressure (kg/sq cm) | $d_h$ (pC/N) |
|---|---|
| 70.31 | 18 |
| 56.25 | 18.6 |
| 42.18 | 17.6 |
| 28.12 | 17.9 |
| 14.06 | 17.9 |
| 7.03 | 17.8 |
| 0 | 17.9 |

## EXAMPLE 3

The following experiment demonstrates the criticality of the proportions used of the components of the composition.

An attempt was made to compound the following formulation according to methods and procedures described in Example 1, except that the proportions were altered and a chloroprene rubber having a Mooney viscosity of 52, sold by Dupont Corporation as "Neoprene GRT", was used.

| Ingredients | Amount (phr) | Density (g/cc) | Volume (cc) |
|---|---|---|---|
| Neoprene GRT | 100 | 1.25 | 80.0 |
| Stearic Acid | 0.5 | 0.84 | 0.6 |
| Magnesium Oxide | 4 | 3.32 | 1.2 |
| Agerite Superlite | 2 | 1.0 | 2.0 |
| Plastogen | 40 | 0.81 | 49.4 |
| Lead Titanate | 2100 | 7.52 | 279.3 |
| Zinc Oxide | 5 | 5.6 | 0.9 |
| Ethylene Thiourea | 1 | 1.0 | 1.0 |

Ingredients were added in the order shown. The resultant mix was unprocessable in the sense that the material would not hold together, flaked badly on the mill during mixing, and required unusual methods, uncommon to rubber processing, for molding of the stock.

Nevertheless, the composition was gathered in flake form and charged to a mold where it was pressed for 50 minutes at 160°C, and 49.21 kg/sq cm in an effort to effect flow of the stock and form it into a slab. The result was a mottled, glassy looking sheet with little flexibility, resembling a ceramic more than an elastomer.

The slab was then prepared for poling by painting silver electrodes on the surfaces of the test sample and applying a voltage. The sample shorted through at 18 kv, on its way to a poling voltage of 20 kv based on 250 volts per 0.025 mm.

## Claims

1. A method of making a piezoceramic composite comprising the steps of:
    (A) mixing together a composition which comprises
    (1) an uncured polar elastomeric chloroprene rubber;
    (2) about 2.5 to about 7.5 phr of an activator/processing aid for said chloroprene rubber;
    (3) about 2 to about 6 phr magnesium oxide; and
    (4) about 30 to about 50 phr of an aliphatic oil plasticizer for said chloroprene rubber;
    (B) mixing into said composition about 1750 to about 3000 phr of a piezoelectric ceramic crystalline powder selected from the group consisting of lead titanate, lead zirconium titanate, and mixtures thereof;
    (C) mixing into said composition about 2.5 to about 7.5 phr zinc oxide and about 0.5 to about 1 phr of a sulfur-containing chloroprene rubber curing agent;
    (D) forming said composition into a shape;
    (E) applying an electrode to opposite sides of said shape;
    (F) curing said chloroprene rubber; and
    (G) applying a DC electric field to said shape through said electrodes.

2. A method according to Claim 1 wherein said chloroprene rubber has a Mooney viscosity of about 42 to about 57.

3. A method according to Claim 1 wherein said mixing is performed on a two roll mill.

4. A method according to Claim 3 wherein said activator/processing aid, said magnesium oxide, said plasticizer, said zinc oxide, and said sulfur-containing chloroprene rubber curing agent are mixed into said composition one-at-a-time in the order recited.

5. A method according to Claim 1 wherein said mixing is performed on a Banbury mixer.

5

6. A method according to Claim 5 wherein said chloroprene rubber, said activator/processing aid, said magnesium oxide, and said plasticizer are added together, and said zinc oxide and said sulfur-containing chloroprene rubber curing agent are added together.

7. A method according to Claim 1 wherein said piezoelectric ceramic crystalline powder is lead titanate.

8. A method according to Claim 7 wherein said lead titanate is prepared by heating powdered crystalline PbTiO₃ in the presence of PbO, thereby growing crystals that have an average equivalent spherical diameter grain size of about 8 to about 15 μm and a grain size distribution, between 10% and 90%, of about 0.3 to about 2.5 times the average, etching said crystals to smooth the surfaces thereof and remove extra-fine particles, for a time sufficient to create an average equivalent spherical diameter grain size of about 12 to about 20 μm, and a grain size distribution, between 10% and 90% of about 0.6 to about 1.35 times the average, and rinsing and drying said etched crystals.

9. A method according to Claim 1 wherein said sheet is partially cured between steps (D) and (E).

10. A method according to Claim 1 wherein said activator/processing aid is stearic acid.

11. A method according to Claim 1 wherein said electrodes are silver paint.

12. A method according to Claim 1 wherein said electrodes are partially cured conductive chloroprene sheets.

13. A method according to Claim 1 wherein said cure is at about 121.11°C to about 232.22°C.

14. A method according to Claim 1 wherein said cure is performed at a pressure of about 3.52 kg/sq cm to about 10.55 kg/sq cm.

15. A method according to Claim 1 wherein said shape is a flat sheet.

16. A method according to Claim 1 wherein said DC electric field is applied perpendicular to a surface of said shape.

17. A method according to Claim 1 wherein said DC electric field is about 100 to about 300 Kv per 0.025 mm of thickness.

18. A method according to Claim 1 wherein said sulfur-containing chloroprene rubber curing agent is ethylene thiourea.

19. A composite made according to the method of Claim 1.

20. A method of making a piezoceramic composite comprising

(A) mixing a high viscosity, semi-solid polar elastomeric chloroprene rubber on a two roll mill;

(B) mixing into said rubber about 2.5 to about 7.5 phr stearic acid;

(C) mixing into said rubber about 2 to about 6 phr magnesium oxide;

(D) mixing into said rubber about 30 to about 50 phr of an aliphatic oil plasticizer;

(E) mixing into said rubber about 1750 to about 3000 phr lead titanate prepared by heating powdered crystalline PbTiO₃ in the presence of PbO, thereby growing crystals that have an average equivalent spherical diameter grain size of about 8 to about 15 μm and a grain size distribution, between 10% and 90%, of about 0.3 to about 2.5 times the average, etching said crystals to smooth the surfaces thereof and remove extra-fine particles, for a time sufficient to create an average equivalent spherical diameter grain size of about 12 to about 20 μm, and a grain size distribution, between 10% and 90% of about 0.6 to about 1.35 times the average, and rinsing and drying said etched crystals;

(F) mixing into said rubber about 2.5 to about 7.5 phr zinc oxide;

(G) mixing into said rubber about 0.5 to about 2.0 phr ethylene thiourea;

(H) forming said rubber into a shape;

(I) partially curing said shape;

(J) securing electrodes to opposite sides of said shape to form a composite;

(K) fully curing said composite; and

(L) applying a DC electric field of about 100 to about 300 Kv per 0.025 mm of thickness to said composite through said electrodes.

21. A composite made according to the method of Claim 20.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| P,A | US-A-4 751 014 (H. OZEKI et al.) * Claim 1; examples * & JP-A-61 270 257 (Cat. A) | | H 01 L 41/22 C 08 L 11/00 |
| A | DATABASE WPI, no. 79-08936B, Derwent Publications Ltd, London, GB; & JP-A-53 145 099 (NIPPON TELEG. & TELEPH.) 16-12-1978 * Abstract * | | |
| A | RUBBER CHEMISTRY AND TECHNOLOGY, vol. 49, no. 3, 1976, pages 650-702, Akron, Ohio, US; P.R. JOHNSON: "Polychloroprene rubber" * Pages 685-688 * | | |

TECHNICAL FIELDS
SEARCHED (Int. Cl.4)

H 01 L
C 08 L

The present search report has been drawn up for all claims

| Place of search | Date of completion of the search | Examiner |
|---|---|---|
| THE HAGUE | 22-09-1988 | VAN HUMBEECK F.W.C. |